# EUROPEAN PATENT APPLICATION

(11) **EP 0 881 694 A1**
(43) Date of publication of application: **02.12.1998**
(21) Application number: 97870081.3
(22) Date of filing: 30.05.1997
(51) Int. Cl.: H01L 31/0224, H01L 31/18

(54) **Solar cell and process of manufacturing the same**

(71) Applicant: INTERUNIVERSITAIR MICRO-ELEKTRONICA CENTRUM VZW, 3001 Heverlee (BE)
(72) Inventor: Van Kerschaver, Emmanuel, 8300 Knokke-Heist (BE); Einhaus, Roland, 3020 Winksele (BE); Szlufcik, Jozef, 3010 Kessel-Lo (BE); Nijs, Johan, 3210 Linden-Lubbeek (BE)
(74) Representative: Van Malderen, Joelle

(57) **Abstract**

A solar cell consisting essentially in a semiconductor substrate having a first region (1) of one conductivity type and a second region (8) of the opposite conductivity type, said substrate being defined by a front radiation receiving surface (2) having a conductive grid and a back surface (3) having separated contacts to the said first region (1) and said second region (8), wherein the conductive grid comprises parallel spaced narrow metal fingers and the contacts to said second region (8) being in the form of wide metal lines connected to the fingers with a limited number of vias (4).

## Description

### Field of the invention

The present invention is related to a new solar cell.

The present invention is also related to a process of realisation of such solar cells.

### Technological background

Most solar cells described in the prior art can be subdivided into several categories according to their general structure.

One of these categories is the group of the so-called back-contacted solar cells, meaning that both ohmic contacts to the two oppositely doped regions of the solar cells are placed on the back or non-illuminated surface of the solar cell. This concept avoids shadowing losses caused by the front metal contact grid on standard solar cells.

The most straightforward way to fabricate back contact solar cells is to place the carrier collecting junction between semiconductor regions of opposite doping close to the back surface of the cell ("back-junction" cell). The document "27.5-Percent Silicon Concentrator Solar Cells" (R.A. Sinton, Y. Kwark, J.Y. Gan, R.M. Swanson, IEEE Electron Device Letters, Vol. ED-7. No. 10, October 1986) describes such a device.

Since the majority of photons are always absorbed close to the front surface of the cell, the generated carriers in these regions have to diffuse through the entire base region of the cell towards the carrier collecting junction close to the back surface. For this concept, high quality material with minority carrier diffusion lengths longer than the cell thickness is needed, which makes this solution not applicable for most solar grade materials which generally have short diffusion lengths.

The largest group of solar cells has the carrier collecting junction close to its front surface. The current from these solar cells is collected by a metal contact to the doped region on the front surface and by a second contact to the oppositely doped region on the back surface. Although this front grid structure can be optimised relatively easily in order to get high collection efficiencies, the trade off between resistance losses and shading losses necessitates a coverage of the front surface by 10-15% of the total area.

Another group of solar cells combines the two approaches. Such solar cells have both external contacts to the oppositely doped regions on the back surface and the collecting junction close to the front surface. The collected current from the front surface is lead through openings, which extend through the entire wafer, to the back surface. Using this structure, shading losses normally arising from the front metallisation grid are greatly reduced.

Several patents make use of this approach.

Documents US-A-4227942 and US-A-4427839 disclose solar cell structures in which the metal contacts to both oppositely doped regions are placed on the back surface of the device. The connection to the front carrier collecting junction is realised by chemically etched vias which are arranged in an array. The metal grids and chemical etch mask are defined by photolithography. Photolithography, however, is an expensive processing step and difficult to implement into industrial production.

The document US-A-4838952 discloses a similar structure wherein an array of holes is created with photolithographically defined areas using chemical etching. In this case, the holes do not extend from the top surface to the back surface of the device. They only extend from the back surface to the junction region. Due to the lower doping density at the junction region compared to the surface where the contacts are normally placed, the contact resistance is expected to be higher with this device if industrial metallisation techniques such as screen printing are used. The disadvantages of photolithography also apply to this method.

The document US-A-3903427 also describes a solar cell with an array of holes, machined by mechanical, electron beam or laser drilling, in order to lead the collected current from the front surface of the solar cell to the back surface. In this case, the metal contacts to the regions of opposite polarity are placed on the back surface, one above the other separated by a dielectric layer. This device makes it also necessary to have an insulating dielectric layer along the walls of the holes. This layer is difficult to combine with industrial metallisation techniques such as screen printing metal paste and firing the metal paste which dissolves dielectric layers.

The document US-A-4626613 discloses solar cells with both contacts on the back surface and an array of holes connecting front and back surface. The holes are used for conducting current from the front surface to the metal grid on the back surface of the appropriate polarity. The holes are machined by laser drilling or by scribing a set of parallel spaced grooves on the front and rear surface. The two sets of grooves on both surfaces are oriented perpendicularly so that after an appropriate etching process, holes are revealed at the points of intersection.

A similar structure is shown in US-A-5468652, wherein the cell structure uses an array of laser drilled holes to conduct current collected on the front surface to the back surface where the metal contacts to the oppositely doped regions are placed. Although this latter case offers also some simplifications to cell processing compared to the ones suggested hereabove, there are still some common drawbacks of cell structures which make use of an array of holes for electrically connecting the two surfaces of a cell.

In order to avoid resistive losses caused by current crowding effects within the heavier doped surface layer of the cell around the holes, the holes need to be spaced 1-1.5 mm to each other in both dimensions. On large area solar cells (10x10cm2) a total number of more than 10000 holes would be necessary. Other difficulties arise from the metallisation point of view. The close spacing of holes demands very narrow alignment tolerances for the two metal grids on the back surface. The large number of holes associated with the structures disclosed in the patents listed above makes these cell structures expensive and not well suited for mass production.

The document US-A-3903428 discloses a solar cell structure that uses one centrally located hole in combination with a metal grid on the cell's front surface to lead the collected current from the front to the back surface. The disclosed structure is best suited for round devices of small area due to increased resistive losses caused by current crowding round the centrally located hole. US-A-3903428 also does not allow a second collecting junction to be placed on the back side of the cells which would be possible with some of the structures discussed above.

### Aim of the present invention

The present invention aims to suggest new solar cells having a structure that overcomes the limitations of the above mentioned structures of the state of the art while maintaining an industrial applicability.

### Main characteristics of the present invention

The first object of the present invention is to suggest a solar cell consisting essentially in a semiconductor substrate, said substrate comprising a first region of one conductivity type and a second region of the opposite conductivity type, said substrate having a front radiation receiving surface with a conductive grid and a back surface with separated contacts to the said first region and said second region, wherein the conductive grid comprises narrow metal fingers and the contacts to said second region are in the form of wide metal lines connected to the fingers with a limited number of vias.

The second region is defined by the doped surface region of the substrate and can be either of n-type or p-type while the first region is then of p-type or n-type.

Preferably, the vias extend from the front surface to the back surface of the substrate and are cone shaped or cylindrical shaped.

The conductive grid on the front surface consists in a number of parallel spaced narrow metal fingers, each in contact with at least one via opening on the front surface.

A second object of the present invention is to suggest a process of realization of such a solar cell.

According to a first embodiment, the process comprises at least the following steps:
- machining a number of vias through the substrate starting from its back surface,
- etching chemically said substrate including said vias,
- diffusing phosphorous or any other dopand in the substrate including the walls of the vias in order to create a second region on the surface of the substrate,
- removing the phosphorsilicate formed on the surface of the solar cell,
- applying the metal contacts to both first and second region on the back surface of the solar cell,
- metallising the vias in a way that the metal forms a conduction path between the back surface and the front surface,
- depositing a conductive grid on the front surface of the substrate on the opening of the vias,
- firing the metal contacts at a temperature comprised between 600°C and 900°C.

According to another preferred embodiment, the process of realization has the following steps:
- machining a number of vias through the substrate starting from its back surface,
- etching chemically said vias, in order to remove the damaged layer resulting from the substrate sewing and from the vias drilling,
- depositing a masking layer on the back surface of the substrate where the base contacts have to be placed,
- diffusing phosphorous or any other dopand in the substrate including the walls of the vias in order to create a second region,
- removing the protective mask and the phosphorsilicate formed on the surface of the cell,
- applying the metal contacts to both first and second region on the back surface of the solar cell,
- metallising the vias in a way that the metal forms a conduction path between the back surface and the front surface,
- depositing a conductive grid on the front surface of the substrate on the opening of the vias,
- firing the metal contacts at a temperature comprised between 600°C and 900°C.

### Brief description of the drawings

- Figures 1: represent an isomeric cross section of a cell at different processing stages of the process of realisation.
- Figures 2 & 3: show possible metal grid concepts for the front surface metallization.
- Figures 4 & 5: show possible metal contacting schemes on the back surface of a solar cell according to preferred embodiments of the present invention.
- Figure 6: shows the series connection of two solar cells on their back surfaces according to a preferred embodiment of the present invention.

### Detailed description of preferred embodiments of the invention

The present solar cell can be described as a back contacted front junction solar cell. The current is collected by metal fingers on the front surface of the cell, and lead to its back surface through a series of vias. Depending on the design of the metallisation patterns on the back surface of the cell, a second collecting junction on the back surface can be realised.

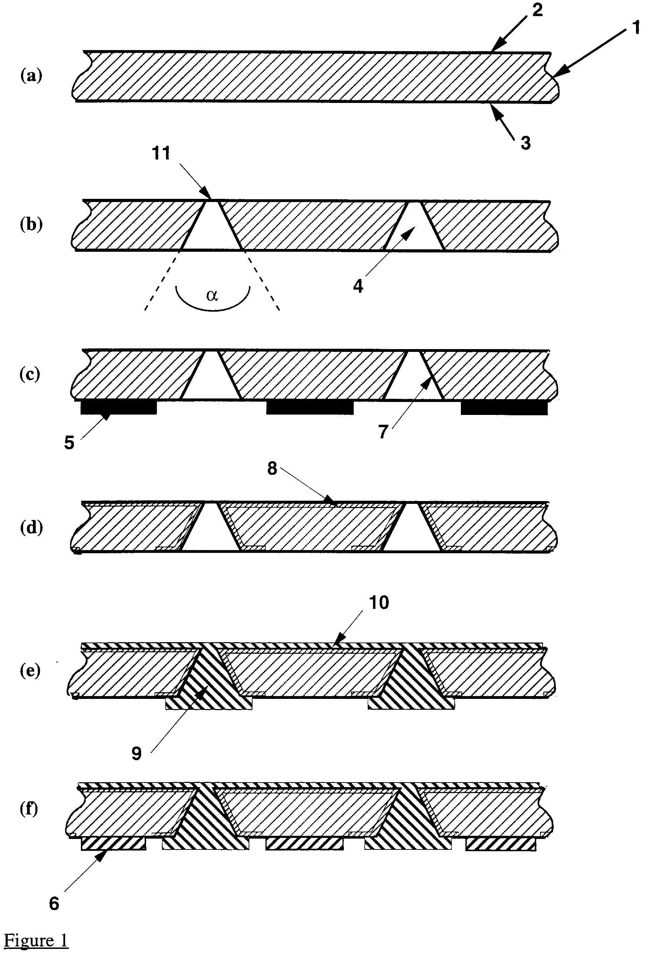

In the following description, a method to produce solar cells with homogeneous emitters is disclosed with reference to figures 1.

The processing sequence for a back-contacted solar cell with a front junction is according to a preferred embodiment as follows:

The starting material is a p-type substrate **1** having a front surface **2** and a back surface **3** as represented on figure 1a.

On figure 1b, a number of vias **4** are machined through the substrate **1**, starting from its back surface **3**. By using a suitable technique, the opening angles α of the vias can be varied. Possible techniques for machining holes with an angle α>0° are mechanical drilling and spark erosion. These techniques are also suitable for creating cylindrical holes (α=0°). In addition, cylindrical holes can also be created with laser drilling, water jet drilling or ultrasonic drilling. Chemical etching can also be used but in this case the definition of the openings with a mask is always necessary which makes this technique unsuitable for industrial application.

Implementing cone shaped vias (with an opening angle α>0°) makes it easier to apply commercial manufacturing techniques like screen printed metallisation as it will be described hereunder. The vias can either extend through the whole substrate **1** from the back **3** to the front surface **2** or extend only to a short distance (<25µm) from the front surface **2** of the substrate **1**. Next, a chemical etching step is performed in order to remove the damaged surface layer resulting from wafer sawing and from the via drilling. If the vias **4** were not extending up to the front surface **2**, sufficient material should be etched off from the front surface **2** to create via openings **11** in the front surface **2**. During the following step, as represented in figure 1c, a suitable masking layer **5** is applied to those regions of the back surface **3** where the base contacts **6** will be placed later on.

Following this step, phosphorous or other suitable dopands can be diffused into the uncovered surfaces of the substrate, including the walls of the vias **7**. The main substrate body of the cell remains bulk p-type silicon. By diffusing the phosphorus into the surfaces, an n-type emitter layer **8** is formed as represented on figure 1d. The phosphorous diffusion into the walls of the holes also serves as an isolation between the p-type bulk of the substrate and the n-type contact through the hole.

Possible phosphorous diffusion techniques are:
(1°) Screen printing a phosphorous containing paste on the areas of the cell where an emitter should be created, drying the paste and using a high temperature furnace step to carry out the diffusion itself from the formed phosphorsilicate glass (PSG) into the surface region of the substrate.
(2°) Using a gaseous source like POCl3 in order to create a PSG on the surface of the substrate from which the diffusion into the surface region is carried out.
(3°) Spin-on and spray-on deposition techniques.
(4°) Other techniques like ion implantation would also be possible but not at an industrial level.

After this diffusion step, the protective mask and the phosphorsilicate glass are removed from the respective surfaces of the cell. A possible cleaning sequence to be achieved consists in removing the PSG by submerging the substrate in diluted HF, followed by a two step cleaning sequence with chemical solutions where the mask is oxidised by a suitable oxidising agent, followed by its removal in diluted HF.

Finally, the metal contacts are applied to the solar cell. This can be realised by using well known metallisation techniques such as screen printing techniques. First, the n-type contact is applied on the back surface of the cell onto those regions that were previously not covered with the mask **5**. At the same time, the vias **4** are metallised **9** in a way that at least the metal forms a conduction path between the front and the back surfaces. Optionally, the vias are metallised in such a way that the metal fills completely the vias extending up to the front surface as represented on figure 1e.

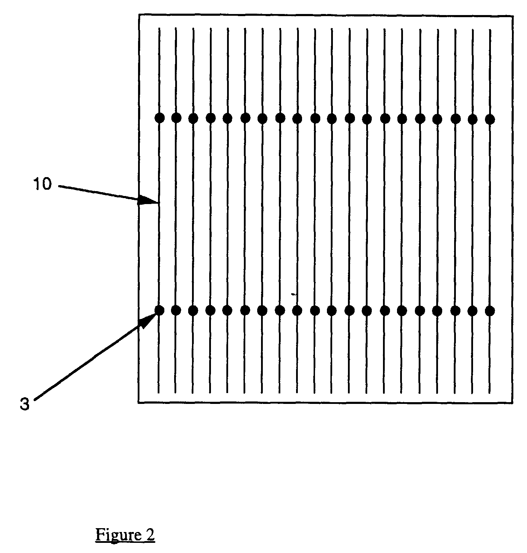

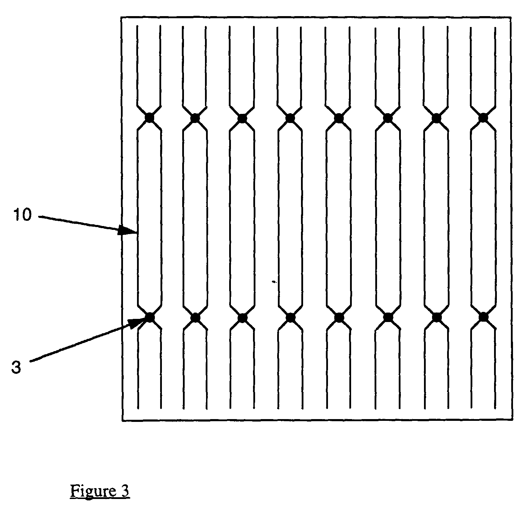

Then, an n-type metal grid **10** is applied to the front surface **2** of the cell in such a way that contact to the already metallised vias is formed as represented on figure 1f. This n-contact grid on the front surface consists in parallel spaced metal fingers, preferably each of them matches a via opening of each row of vias (see figures 2 and 3). Variations of this front metal grid are possible and described hereunder.

The contacting of the n-type emitter on both surfaces can also be realised in reverse order to the one just described. As a last step, the p-type contact to the cell is formed on the back surface by screen printing a third grid of metal lines **6** on the regions that were previously covered with the protecting mask **5** and interdigitated with the aforementioned n-type grid on the back surface. After the application of the metal contacts they are fired at a relatively high temperature in order to establish electrical contact to the semiconductor. Depending on the composition of the metal paste the firing temperatures range from 600° to 900° C.

A significant problem arising from solar cell processes like the one described is the isolation between the p-type and the n-type contacts in order to avoid shunt conductances. The process sequence described above solves this problem by preventing emitter formation in the p-type regions. Other solutions to avoid this shunting conductance without applying a mask before the emitter diffusion exist. Among these are:
(1°) Removal of parts of the emitter region for the p-type contact after diffusion by means of laser-scribing, dicing with mechanical saws or spark erosion.
(2°) Selective chemical etch of an emitter region for the p-type contact.
(3°) Separation of the p-type contact region from the n-type contact region by mechanical means or chemical etching after firing the metal contacts.
(4°) Formation of a lightly doped p-type region extending from the back surface into the bulk region by Aluminium alloying or diffusion of an appropriate dopand such as boron. This region can afterwards be contacted by using a conductive grid.

Based on the most essential process sequence as described hereabove, further processing steps known to the man skilled in the art can be added in order to further improve the performance of the cells:
(1°) Following the cleaning step after the hole formation, a surface structuring step can be included. The aim of surface structuring is to reduce the reflection from the front surface of the cell which allows more light to enter the cell and thus leads to a higher current output of the cell. Several techniques for surface structuring are known to the man skilled in the art.
(2°) In order to passivate the surfaces of the cell, an oxidation can be carried out after the emitter diffusion step. The resulting SiO₂ layer does not form any barrier for the application of metal contacts to the silicon. Techniques to contact the silicon through the oxide with metal grids are well established.
(3°) The front surface of the solar cell may be covered with an Anti-Reflection Coating (ARC) layer in order to further reduce reflection losses.

The following are possible variations of the front metal grid described hereabove consisting a number of parallel spaced fingers whose total number matches exactly the number of vias in one row of vias:
(1°) The number of vias does not have to correspond to the number of fingers. A design where more than one finger is connected to one via can be realised as shown in figure 3. An advantage of this layout is a further reduction of the total number of vias which can speed up the manufacture processing of holes. (2°) Other front contact grids other than parallel fingers can also be combined with vias to lead the collected current to the back surface.
(3°) The vias do not necessarily have to be placed along two lines. Alternative placements of the vias corresponding to the front metallisation are a design option as well.

The disclosed solar cell structure according to the present invention can also be used for cells with selective emitters. Cells with selective emitters have a heavily doped region with sheet resistivities less than 40 Ω/square adjacent to the emitter metal contact and lightly doped regions with sheet resistances higher than 40 Ω/square on the open areas of the cells that receive the incident light.

Instead of using p-type substrates as starting material it is also possible to apply the above mentioned processing steps to n-type substrates with corresponding reversals of following regions in a cell of certain conductivity compared to the descriptions hereabove.

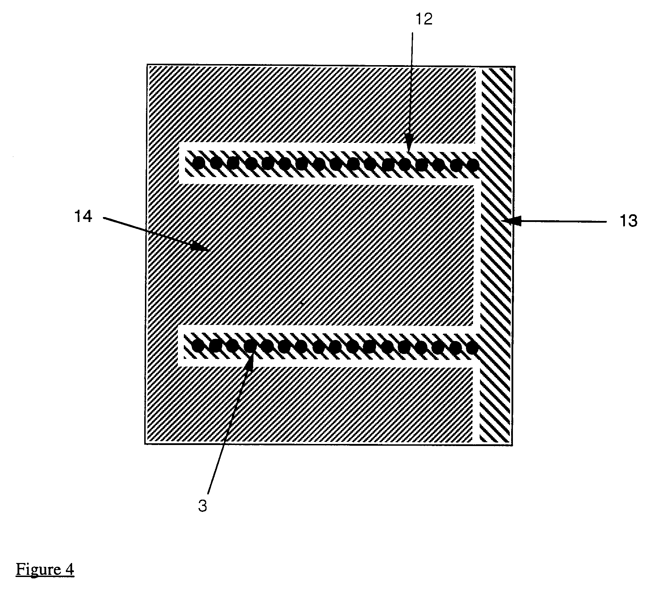

Figure 4 shows an example of the design of the back side of the solar cell. The n-type metallisation **12** on the back surface only consists of two conductive leads over an area where the vias **4** leading to the front surface are placed. Perpendicular to these lines, there is a wide conductive lead **13** at the edge of the cell to allow interconnection to neighbouring cells on the module. The remainder of the cell area is used as base contact **14**. The reader will understand that instead of using a full coverage for the base contact, gridded patterns are possible.

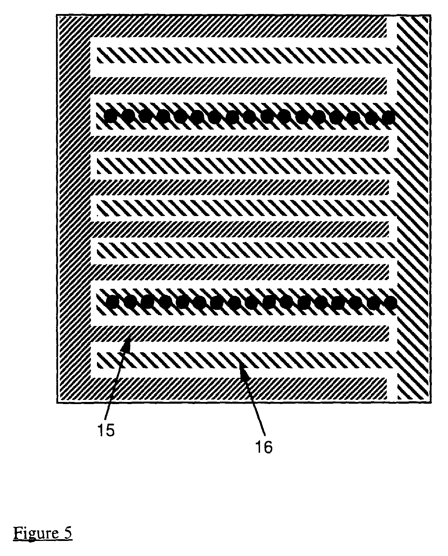

Figure 5 gives an example of an alternative back surface metallisation design. In this case, the junction that is formed between the emitter on the back side of the cell and the substrate body is contacted and used as a second carrier collecting junction in addition to the first collecting junction on the front surface. This design results in an interdigitated structure consisting of contact fingers to the base **15** and contact fingers to the back surface emitter **16**.

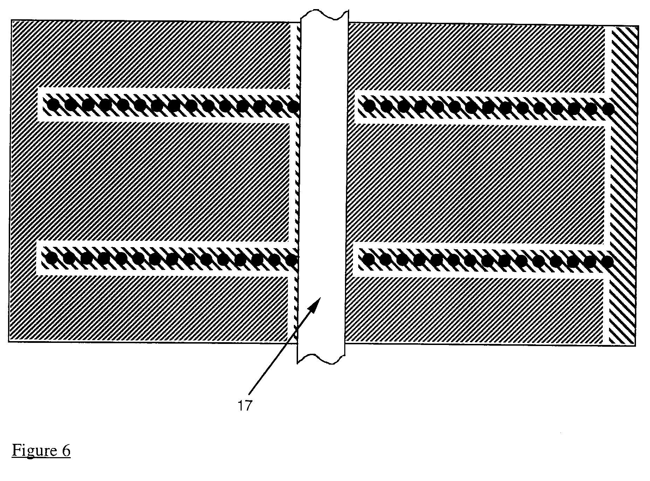

Back metallisation structures like the ones described offer the possibility of easy electrical interconnection between single solar cells. As an example, to Figure 6 shows the series connection between two cells that can be realised by placing the cells next to each other, with the n-type connector at the edge of the first cell adjacent to the p-type connector at the edge of the second cell. The electrical connection can be easily established by applying a wide conductive lead **17** over both connectors. This way of cell interconnection gives rise to a dense packing of cells in a module and is much more simplified than the connection of conventional cells for which it is necessary to lead a connecting wire from the front surface of one cell to the back surface of the next cell.

## Claims

1. A solar cell consisting essentially in a semiconductor substrate, said substrate comprising a first region (1) of one conductivity type and a second region (8) of the opposite conductivity type, said substrate having a front radiation receiving surface (2) with a conductive grid and a back surface (3) with separated contacts to the said first region (1) and said second region (8), wherein the conductive grid comprises narrow metal fingers and the contacts to said second region (8) are in the form of wide metal lines connected to the fingers with a limited number of vias (4).

2. A solar cell according to claim 1, wherein the second region (8) is the doped surface region of the substrate.

3. A solar cell according to claim 2, characterized in that the first region of the substrate is of p-type while the doped surface region is of the n-type.

4. A solar cell according to claim 2, characterized in that the first region of the substrate is of n-type while the doped surface region is of the p-type.

5. A solar cell according to any one of the preceding claims, wherein the vias (4) extend from the front surface (2) to the back surface (3) of the substrate.

6. A solar cell according to any one of the preceding claims, wherein the vias (4) are cone shaped or cylindrical shaped vias.

7. A solar cell according to any one of the preceding claims, wherein the conductive grid on the front surface consists in a number of parallel spaced narrow metal fingers, each in contact with at least one via opening on the front surface.

8. A solar cell according to claim 7, wherein the conductive grid on the front surface (2) consists in a number of narrow metal fingers those total number is more than the number of vias in one row of vias.

9. A solar cell according to claim 8, wherein the conductive grids consist in a number of parallel spaced fingers those total number matches exactly the number of vias in one row of vias.

10. A solar cell according to any one the preceding claims, wherein an anti-reflection coating layer is deposited on the front surface (2).

11. A solar cell according to any one of the preceding claims, wherein the number of vias is less than 100 for cells having an area smaller than about 10 x 10 cm.

12. A process of realisation of a solar cell consisting essentially in a semiconductor substrate having a first region (1) of one conductivity type and a second region (8) of the opposite conductivity type, said substrate being defined by a front surface (2) intended to receive the radiation and a back surface (3) intended to receive the contacts to the first region and the second regions, said process comprising the following steps:
- machining a number of vias (4) through the substrate starting from its back surface (3),
- etching chemically said substrate including said vias (4),
- diffusing phosphorous or any other dopand in the substrate including the walls (7) of the vias (4) in order to create a second region (8) on the surface of the substrate,
- removing the phosphorsilicate formed on the surface of the solar cell,
- applying the metal contacts to both first and second region on the back surface of the solar cell,
- metallising the vias in a way that the metal forms a conduction path between the back surface (3) and the front surface (2),
- depositing a conductive grid on the front surface of the substrate on the opening of the vias (4),
- firing the metal contacts at a temperature comprised between 600°C and 900°C.

13. A process of realisation of a solar cell consisting essentially in a semiconductor substrate having a first region (1) of one conductivity type and a second region (8) of the opposite conductivity type, said substrate being defined by a front surface (2) intended to receive the radiation and a back surface (3) intended to receive the contacts to the first region and the second regions, said process comprising the following steps:
- machining a number of vias (4) through the substrate (1) starting from its back surface (3),
- etching chemically said vias (4), in order to remove the damaged layer resulting from the substrate sewing and from the vias drilling,
- depositing a masking layer (5) on the back surface (3) of the substrate where the base contacts have to be placed,
- diffusing phosphorous or any other dopand in the substrate including the walls (7) of the vias (4) in order to create a second region (8),
- removing the protective mask (5) and the phosphorsilicate formed on the surface of the cell,
- applying the metal contacts to both first and second region on the back surface of the solar cell,
- metallising the vias in a way that the metal forms a conduction path between the back surface (3) and the front surface (2),
- depositing a conductive grid on the front surface of the substrate on the opening of the vias (4),
- firing the metal contacts at a temperature comprised between 600°C and 900°C.

14. A process of realisation of solar cell according to claim 12 or 13, further comprising the steps of:
- depositing a masking layer (5) on the back surface (3) of the substrate where the base contacts have to be placed,
- diffusing the dopand into the not covered surface by the mask of the substrate including the walls (7) of the vias (4) in order to create a second region (8),
- removing the protective mask (5) and the phosphorsilicate formed on the surface of the cell after the step of etching a substrate.

15. A process according to any one of the claims 12 to 14, wherein in the case that the vias are not extending from the back surface (3) up to the front surface (2), sufficient material of the substrate is etched off from the formed surface in order to create vias openings on the front surface.

16. A process according to any one of the preceding claims 12 to 15, wherein the phosphorous diffusion is performed by screen printing a phosphorous containing paste on the areas of the cell where an emitter should be created, drying the paste and using a high temperature furnace step to carry out the diffusion itself from the formed phosphorsilicate glass (PSG) into the surface region of the substrate.

17. A process according to any one of the preceding claims 12 to 15, wherein the phosphorous diffusion is performed by using a gaseous source like POCl3 in order to create a PSG on the surface of the substrate from which the diffusion into the surface region is carried out.

18. A process according to any one of the preceding claims 12 to 15, wherein the phosphorous diffusion is performed by spin-on or spray-on deposition techniques.

19. A process according to any one of the preceding claims, wherein the phosphorous diffusion is performed by ion implantation technique.

20. A process according to any one of the preceding claims 12 to 19, wherein the removal of the protective mask and the phosphorsilicate glass is achieved by submerging the substrate in dilute HF followed by a two-step cleaning sequence with chemical solutions where the mask is oxidised by an oxidising agent followed by its removal in dilute HF.

21. A process according to any one of the preceding claims, wherein the depositing of the metal contacts is performed by screen printing techniques.
